# EUROPÄISCHE PATENTSCHRIFT

(11) **EP 2 796 022 B1**
(45) Veröffentlichungstag und Bekanntmachung des Hinweises auf die Patenterteilung: **18.07.2018**
(21) Anmeldenummer: 12794896.6
(22) Anmeldetag: 14.11.2012
(51) Int. Cl.: H05K 5/00, F16H 61/00, H05K 7/20, H05K 1/14

(54) **STEUERGERÄT UND VERFAHREN ZUM HERSTELLEN EINES STEUERGERÄTS FÜR EIN KRAFTFAHRZEUG**
CONTROL DEVICE AND METHOD FOR PRODUCING A CONTROL DEVICE FOR A MOTOR VEHICLE
MODULE DE COMMANDE ET PROCÉDÉ DE FABRICATION D'UN DISPOSITIF DE COMMANDE POUR UN VÉHICULE AUTOMOBILE

(30) Priorität: 19.12.2011 DE 102011088970
(43) Veröffentlichungstag der Anmeldung: 29.10.2014
(73) Patentinhaber: Robert Bosch GmbH, 70442 Stuttgart (DE)
(72) Erfinder: LISKOW, Uwe, 71679 Asperg (DE); KLOBES, Peter, 76467 Bietigheim (DE); MEIER, Thomas, 71739 Oberriexingen (DE)
(86) Internationale Anmeldenummer: PCT/EP2012/072610
(87) Internationale Veröffentlichungsnummer: WO 2013/092014

(56) Entgegenhaltungen:
- DE-A1- 3 916 899
- DE-A1- 19 859 739
- DE-A1- 19 907 949
- US-A1- 2004 035 245

## Beschreibung

### Stand der Technik

Zur Steuerung von diversen Anwendungen im Kraftfahrzeugbau sind elektronische Steuerungsgeräte erforderlich. Die elektronischen Steuergeräte enthalten elektronische Bauelemente wie Steuermodule zum Ansteuern von Aktuatoren und Sensoren sowie wenigstens eine Steckverbindung zum Anschluss an einen Fahrzeugkabelbaum. Zur Steuerung von modernen Automatikgetrieben sind elektronische Steuerungsmodule erforderlich, die in vielen Fällen im Inneren des Getriebegehäuses angeordnet sind. Hierbei werden die Steuermodule so verbaut, dass sie ganz oder teilweise von Getriebeöl bedeckt sind und Temperaturen von -40 °C bis +150 °C, die in derartigen Getrieben auftreten können, ausgesetzt sind. Derartige Steuermodule entwickeln während des Betriebs eine große Wärmemenge, die abgeführt werden muss, um eine Überhitzung derartiger Steuermodule zu verhindern. Es ist bekannt, diese Steuermodule an sogenannten Trägerplatten, die aus Aluminium gefertigt sind und eine Stärke von etwa 5mm aufweisen, fest anzuordnen, um die von dem Steuermodul abgegebene Wärme in die Trägerplatte einzuleiten. Das Steuermodul ist hierbei von einer Leiterplatte umgeben, mit der das Steuermodul kontaktiert ist. Die Leiterplatte ist mit der Trägerplatte aus Stabilitätsgründen fest verbunden wie beispielsweise durch Kleben, Schrauben oder Nieten. Allerdings bilden derartige Trägerplatten nicht nur eine Wärmesenke, sondern aufgrund ihres Volumens auch einen Wärmespeicher. Zudem sind derartige Steuergeräte aufgrund des Gewichts der Trägerplatte recht schwer, wobei die Trägerplatte fünfzig Gewichtsprozent und mehr Gewichtsanteil an dem Gesamtgewicht des Steuermoduls haben kann.

Aus der US 2004/0035245 A1 ist ein Steuergerät für ein Kraftfahrzeug mit den Merkmalen des Oberbegriffs des unabhängigen Anspruchs 1 bekannt. Durch Einlegung eines Wärmeleitkörpers in eine mit einer Leiterplatte oder Stanzgitterteilen versehene Kunststoffplatte sind zwischen Kunststoffplatte und Wärmeleitkörper Fluidkanäle für ein Kühlmedium ausgebildet.

Aus der DE 39 16 899 A1 ist ein Steuergerät bekannt, bei dem ein elektrisches Bauelement auf einem Wärmeabführelement angeordnet ist, dass in einen Kunststoffträger eingelassen ist.

Aus der DE 198 59 739 A1 ist eine Kühlvorrichtung zur Verwendung in einem elektronischen Steuergerät bekannt, bei der ein Baugruppenträger auf der Unterseite mit einem Kühlkörper versehen ist und ein Bauelement über eine Wärmeleitplatte in einer Aussparung des Baugruppenträgers auf dem Kühlkörper angeordnet ist.

Aus der DE 199 07 949 A1 ist eine Steuergerät für ein Kraftfahrzeug bekannt, bei der eine Trägerstruktur eine Bodenplatte flächig fortsetzt. Auf der Bodenplatte verläuft eine flexible Leiterplatte, die eine elektronische Schaltung des Steuergerätes kontaktiert. Ein Gehäusedeckel ist öldicht mit der Bodenplatte gekoppelt.

### Zusammenfassung der Erfindung

Somit kann ein Bedürfnis bestehen, ein Steuergerät bereitzustellen, welches in verbesserter Weise Wärme von dem Steuerungsmodul abführen kann.

Das Bedürfnis kann befriedigt werden durch den Gegenstand der unabhängigen Patentansprüche. Vorteilhafte Ausgestaltungen der Erfindung ergeben sich durch die Gegenstände der abhängigen Patentansprüche.

Gemäß einem ersten Ausgestaltungsbeispiel der Erfindung wird ein Steuergerät für ein Kraftfahrzeug bereitgestellt, wobei das Steuergerät einen ersten Schaltungsträger mit miteinander elektrisch leitfähig verbundenen elektrischen Bauelementen und einen zweiten Schaltungsträger mit miteinander elektrisch leitfähig verbundenen elektrischen Bauelementen aufweist. Der erste Schaltungsträger und der zweite Schaltungsträger sind miteinander elektrisch leitfähig verbunden. Der zweite Schaltungsträger ist mit einem fluiddichten wärmeleitfähigen Trägerelement wärmeleitfähig fest verbunden. Der erste Schaltungsträger weist eine Ausnehmung auf, wobei der zweite Schaltungsträger in der Ausnehmung angeordnet ist. Das Trägerelement ist in der Ausnehmung angeordnet. Das Trägerelement weist eine bessere Wärmeleitfähigkeit als der erste Schaltungsträger auf. Das Trägerelement ist an eine Wärmesenke wärmeleitfähig verbindbar. Das Trägerelement ist in einem Innenbereich des ersten Schaltungsträgers fluiddicht integriert.

Das Trägerelement kann von dem ersten Schaltungsträger vollständig umschlossen sein bis auf zwei Bereiche. An den einen Bereich ist die Wärmesenke an das Trägerelement koppelbar und an den anderen Bereich ist der zweite Schaltungsträger an das Trägerelement fest verbunden ist. Hierbei kann das Trägerelement beispielsweise durch Einbetten oder Einlaminieren in den ersten Schaltungsträger eingebracht sein. Das Trägerelement kann derart selbsttragend ausgebildet sein, dass der zweite Schaltungsträger durch das Trägerelement auch unter Einfluss eines Fluids als Wärmesenke stabil gehalten ist. Der zweite Schaltungsträger kann an das Trägerelement beispielsweise mittels technischer Federn angedrückt sein. Auch kann der zweite Schaltungsträger an das Trägerelement geklebt sein. Die Verbindung zwischen dem zweiten Schaltungsträger und dem Trägerelement kann derart gestaltet sein, dass der zweite Schaltungsträger direkt an das Trägerelement seine Wärme abgeben kann, wobei zwischen dem zweiten Schaltungsträger und dem Trägerelement keine Wärmeisolationsschicht wie beispielsweise Leiterplattenmaterial besteht. Der zweite Schaltungsträger kann ferner als Steuermodul zur Steuerung von Getriebefunktionen in modernen Automatikgetrieben ausgebildet sein. Der erste Schaltungsträger wird in der Regel als eine starre Leiterplatte ausgebildet sein, wobei die Leiterplatte aus Glasfasergewebe und Epoxydharz besteht und damit eine Qualität von FR4 oder mehr aufweist. Hierbei steht FR für Flame Retardent (flammenhemmend). Die Leiterplatte kann als Niederstromleiterplatte mit beispielsweise 35 µm bis 70 µm dicken Kupferbahnen oder als Hochstrom-Leiterplatte mit beispielsweise 100 µm bis 400 µm dicken Kupferbahnen ausgebildet sein. Auch können Hochstrompfade mit einer Dicke von mehr als 400 µm, also beispielsweise 1 mm, 2 mm oder mehr, in die Leiterplatte eingelegt sein. Auch kann beispielsweise der erste Schaltungsträger einen sich von einer Oberseite zu einer der Oberseite gegenüberliegenden Unterseite erstreckenden Durchbruch aufweisen, der von dem beispielsweise 1mm dicken, sich in Längserstreckungsrichtung des ersten Schaltungsträgers erstreckenden Trägerelement fluiddicht verschlossen. Hierbei kann das Trägerelement an einer Seitenwandung des Durchbruchs enden oder größer als der Durchbruch gestaltet sein und entsprechend in den ersten Schaltungsträger hineinragen. Wenn das Steuergerät beispielsweise in einem Automatikgetriebe eines Kraftfahrzeugs verwendet wird, das Steuergerät sich also innerhalb des Getriebegehäuses des Automatikgetriebes befindet, kann beispielsweise auch das Automatikgetriebeöl als Wärmesenke verwendet werden. Hierbei kann das Automatikgetriebeöl derart an das Trägerelement herangeführt sein, dass das Automatikgetriebeöl die durch den zweiten Schaltungsträger erzeugte Wärme, die in das Trägerelement eingeleitet ist, von dem Trägerelement ableiten kann. Auch kann das Getriebegehäuse selbst oder eine in dem Getriebegehäuse angeordnete Steuerplatte als Wärmesenke ausgebildet sein. Hierbei wird das Trägerelement wärmeleitfähig mit dem Getriebegehäuse oder der Steuerplatte verbunden. Das Trägerelement kann derart gestaltet sein, dass eine erste Aufnahmefläche für den zweiten Schaltungsträger und/oder ein zweite Aufnahmefläche für die Wärmesenke ausgebildet sind. Hierbei kann die zweite Aufnahmeflächen für die Wärmesenke derart ausgebildet sein, dass an die zweite Aufnahmefläche ein Festkörper wärmeleitend verbindbar ist oder dass die zweite Aufnahmefläche Leitflächen zum Leiten eines flüssigen oder gasförmigen Fluids aufweist. Das Trägerelement kann fluiddicht ausgebildet sein. Die zweite Aufnahmefläche des Trägerelements kann benachbart zu der ersten Aufnahmefläche oder der ersten Aufnahmefläche gegenüberliegend angeordnet sein. In der Regel wird die zweite Aufnahmefläche der ersten Aufnahmefläche gegenüberliegend ausgebildet sein, da bei einer derartigen Ausgestaltung die Wärmesenke näher an den zweiten Schaltungsträger angeordnet sein kann. Die zweite Aufnahmefläche kann beispielsweise plan ausgebildet sein. Wenn die zweite Aufnahmefläche der ersten Aufnahmefläche gegenüberliegend angeordnet ist, kann die zweite Aufnahmefläche bündig mit einer Seite des als Leiterplatte ausgebildeten ersten Schaltungsträgers sein. Die erste Aufnahmefläche kann beispielsweise ebenfalls plan ausgebildet sein. Damit kann das Trägerlement plattenförmig ausgebildet sein. Da das Trägerelement dünner ausgebildet sein kann als der erste Schaltungsträger, kann die erste Aufnahmefläche gegenüber einer anderen Seite des als Leiterplatte ausgebildeten ersten Schaltungsträgers zurückstehen, so dass der zweite Schaltungsträger zumindest teilweise innerhalb des ersten Schaltungsträgers angeordnet sein kann. So kann das Steuergerät flach ausgestaltet sein. Durch die geringe Dicke des Trägerlements kann zudem die durch den zweiten Schaltungsträger erzeugte Wärme nahezu verlustfrei in die Wärmesenke geleitet werden. Das Trägerelement, obzwar möglicherweise elektrisch leitfähig ausgestaltet, wird ausschließlich zur Übertragung von Wärme verwendet, jedoch nicht zur Übertragung von elektrischem Strom. In der Regel wird der erste Schaltungsträger und der zweite Schaltungsträger mittels Bonddrähten elektrisch leitfähig miteinander verbunden sein, wobei zur Fertigungsvereinfachung die Bonddrähte an dem zweiten Schaltungsträger angeordnet sein können. Um jedoch eine gute Wärmeableitung aus dem zweiten Schaltungsträger in das Trägerelement zu gewährleisten, wird der zweite Schaltungsträger umlaufend von dem ersten Schaltungsträger beabstandet sein. Als Vorteil kann angesehen werden, dass der erste Schaltungsträger in Verbindung mit dem Trägerelement derart eigenstabil ist, dass der erste Schaltungsträger nicht auf eine bekannte Trägerplatte zur Stabilisierung montiert zu werden braucht. Weiterhin kann mittels einer Wärmesenke die durch den zweiten Schaltungsträger erzeugte Wärme schnell mit lediglich geringem Wärmewiderstand abgeführt werden. Aufgrund des geringen Volumens des Trägerelements, wobei das spezifische Gewicht des Trägerelements in der Regel größer sein wird als das spezifische Gewicht des ersten Schaltungsträgers, kann das Steuergerät erheblich leichter gestaltet werden als ein aus dem Stand der Technik bekanntes Steuergerät.

Gemäß einem weiteren Ausgestaltungsbeispiel der Erfindung weist das Trägerelement einen Randbereich mit einer ersten Seite und einer der ersten Seite gegenüberliegenden zweiten Seite auf, wobei sowohl die erste als auch die zweite Seite zumindest teilweise von dem ersten Schaltungsträger überdeckt sind.

Der erste Schaltungsträger, insbesondere, wenn als flächige Leiterplatte ausgebildet, kann eine Oberseite und eine der Oberseite gegenüberliegende Unterseite aufweisen, wobei das Trägerelement zwischen der Oberseite und der Unterseite mit dem ersten Schaltungsträger unlösbar verbunden ist. Damit kann sich das Trägerelement innerhalb des ersten Schaltungsträgers befinden. Das Trägerelement kann zumindest an seinen Verbindungsstellen mit dem ersten Schaltungsträger von der Oberseite und der Unterseite des Schaltungsträgers überdeckt sein. Das Trägerelement kann beispielsweise während der Herstellung des ersten Schaltungsträgers in die Leiterplatte eingelegt, respektive einlaminiert werden. Unter Einlaminieren ist in der Regel zu verstehen, dass das Trägerelement in den ersten Schaltungsträger beispielsweise mittels Epoxydharz, Phenolharz oder anderen Harzen während des Fertigungsprozesses der Leiterplatte integriert wird. Die als erster Schaltungsträger ausgebildete Leiterplatte besteht in der Regel aus mindestens zwei Leiterplattenschichten. Eine 4-lagigen Leiterplatte entsteht in der Regel durch ein beidseitiges Beschichten eines beidseitig mit Kupfer beschichteten Innenlage-Kerns zunächst mit einem Prepreg und abschließend mit einer Kupferfolie. Hierbei können die vorgefertigten Leiterplattenlagen bereits Aussparungen enthalten, in die das Trägerelement während des Laminierens der einzelnen Leiterplattenschichten eingelegt wird. Da die einzelnen Leiterplattenschichten in der Regel mittels Harz miteinander verbunden werden, das unter Druck und Wärme ausgehärtet wird, kann während dieses Prozesses das Trägerelement in den ersten Schaltungsträger eingearbeitet werden. So kann beispielsweise der erste Schaltungsträger mit dem Trägerelement eine Dicke von etwa 2 mm aufweisen, während das Trägerelement beispielsweise lediglich als eine 1 mm dicke Platte ausgestaltet ist.

Gemäß einem weiteren Ausgestaltungsbeispiel der Erfindung erstreckt sich das Trägerelement entlang einer Längserstreckungsrichtung des ersten Schaltungsträgers.

Gemäß einem weiteren Ausgestaltungsbeispiel der Erfindung ist das Trägerelement plattenförmig ausgebildet.

Hierbei ist das Trägerelement besonders einfach und preisgünstig herzustellen und in einfacher Weise innerhalb des ersten Schaltungsträgers anzuordnen. Hierzu kann die Platte beispielsweise aus einem Blech geschnitten sein. Die Platte wird in der Regel derart gestaltet sein, dass ihre Abmaße in Erstreckungsrichtung des ersten Schaltungsträgers kleiner sind als die Abmaße des ersten Schaltungsträgers, so dass die Schmalflächen des Trägerlements von dem ersten Schaltungsträger umschlossen sind.

Gemäß einem weiteren Ausgestaltungsbeispiel der Erfindung weist das Trägerelement eine Dicke auf, wobei die Dicke größer als 0,4 mm ist.

Bei dieser Dicke kann das Trägerelement eine ausreichende Stabilität zur Aufnahme des zweiten Schaltungsträgers und zur Aufnahme der Wärmesenke aufweisen. Jedoch wird das Trägerelement in der Regel eine Dicke von etwa 1mm aufweisen.

Gemäß einem weiteren Ausgestaltungsbeispiel der Erfindung ist das Trägerelement aus einem Werkstoff gefertigt, der ausgewählt ist aus der Gruppe Kupfer, Kupferlegierung, Aluminium, Aluminiumlegierung und Nickellegierung.

Gerade diese Werkstoffe haben eine ausgezeichnete Wärmeleitfähigkeit, um die von dem zweiten Schaltungsträger erzeugte Wärme möglichst verlustfrei in die Wärmesenke zu leiten. Ein typischer Vertreter der Nickellegierung in Verbindung mit guter Wärmeleitfähigkeit ist Neusilber. Da das Trägerelement elektrisch isolierend ausgestaltet sein kann, kann als Trägerelement auch ein gut wärmeleitfähiger Kunststoff verwendet werden. In der Regel ist aufgrund unterschiedlicher Wärmeausdehnungskoeffizienten des Basismaterial der Leiterplatte und des Materials des Trägerelements die beiden Materialien derart aufeinander abzustimmen, dass im späteren Betrieb keine Delamination von Trägerelement und Leiterplatte eintritt.

Gemäß einem weiteren Ausgestaltungsbeispiel der Erfindung ist die erste Ausnehmung des ersten Schaltungsträgers als eine erste Aussparung ausgebildet, wobei die erste Aussparung derart wannenförmig ausgebildet ist, dass eine erste Seitenwandung von dem ersten Schaltungsträger gebildet ist. Die erste Seitenwandung und das Trägerelement sind miteinander fluiddicht verbunden.

Somit kann der zweite Schaltungsträger innerhalb des ersten Schaltungsträgers angeordnet, wobei der Gesamtaufbau des Steuergerätes gering sein kann.

Gemäß einem weiteren Ausgestaltungsbeispiel der Erfindung weist der erste Schaltungsträger eine von der ersten Aussparung verschiedene zweite Aussparung auf. Die zweite Aussparung ist derart wannenförmig ausgebildet, dass eine zweite Seitenwandung von dem ersten Schaltungsträger gebildet ist. Die zweite Seitenwandung und das Trägerelement sind miteinander fluiddicht verbunden.

Somit können die beiden Aussparungen in dem ersten Schaltungsträger einander benachbart oder einander geneüberliegend angeordnet sein. Die Aussparungen können bei der Fertigung des Schaltungsträgers vorgesehen sein, indem an den Stellen der Aussparungen kein Material vorgesehen ist wie Glasfasermatte und/oder Epoxydharz. Die Aussparungen können auch nach der Fertigung des ersten Schaltungsträgers ausgebildet werden, indem das das Trägerelement bedeckende Leiterplattenmaterial durch mechanische Bearbeitung wie beispielsweise Fräsen entfernt wird.

Gemäß einem weiteren Ausgestaltungsbeispiel der Erfindung ist die zweite Aussparung als eine Nut ausgebildet, wobei sich die Nut von einer ersten Seitenfläche des ersten Schaltungsträgers zu einer von der ersten Seitenfläche verschiedenen zweiten Seitenfläche des ersten Schaltungsträgers erstreckt.

Gerade eine Nut bietet sich insbesondere dann an, wenn die Wärmesenke ein flüssiges oder gasförmiges Fluid ist. Durch die Nut kann das Fluid entsprechend gelenkt werden, um die von dem zweiten Schaltungsträger erzeugte und in das Trägerelement eingebrachte Wärme möglichst rasch von dem Trägerelement wegzubringen.

Gemäß einem weiteren Ausgestaltungsbeispiel der Erfindung sind die erste Aussparung und die zweite Aussparung in einer Flucht angeordnet.

Damit können die erste Aussparung und die zweite Aussparung einander gegenüberliegend angeordnet sein, wobei die erste Aussparung von der zweiten Aussparung durch das Trägerelement getrennt ist. In Verbindung mit dem dünnen plattenförmigen Trägerelement ist der Wärmetransport besonders effektiv, da die Wärmesenke und der Wärmeerzeuger, nämlich der zweiten Schaltungsträger, einander gegenüberstehen und lediglich durch das Trägerelement voneinander getrennt sind.

Gemäß einem weiteren Ausgestaltungsbeispiel der Erfindung ist die erste Aussparung und die zweite Aussparung deckungsgleich.

Hierdurch ist eine besonders einfache Fertigung von einzelnen Leiterplattenlagen möglich, die zu einem späteren Zeitpunkt zu einer Gesamtleiterplatte, nämlich dem ersten Schaltungsträger, verbunden werden. Dadurch, dass die erste Aussparung und die zweite Aussparung deckungsgleich sind, kann das Trägerelement lediglich geringfügig größer gestaltet sein als eine der beiden Aussparungen.

Gemäß einem weiteren Ausgestaltungsbeispiel der Erfindung ist der zweite Schaltungsträger auf Basis von gesinterten Keramikträgern hergestellt.

Ein typischer Vertreter dieser Technologie ist LTCC (Low Temperature Cofired Ceramics) oder ein Keramiksubstrat in Dickschichttechnologie. Hierbei ist der Schaltungsträger aus einem gut wärmeleitenden Werkstoff, nämlich Keramik, gefertigt. Die Wärmeleitfähigkeit des zweiten Schaltungsträgers kann erheblich größer sein als die Wärmeleitfähigkeit des ersten Schaltungsträgers, insbesondere, wenn der erste Schaltungsträger aus Glasfaser und Harz gefertigt ist. Dadurch kann die von dem ersten Schaltungsträger erzeugte Wärme schnell in das Trägerelement eingeleitet werden. Natürlich kann der zweite Schaltungsträger auch als eine ein- oder mehrlagige Leiterplatte ausgebildet, wobei der zweite Schaltungsträger auch als HDI(High-Density-Interconnect)-Leiterplatte ausgestaltet sein kann.

Gemäß einem weiteren Ausgestaltungsbeispiel der Erfindung sind der zweite Schaltungsträger und das Trägerelement miteinander verklebt.

In der Regel wird der Klebstoff gut wärmeleitend ausgebildet sein, um schnell die Wärme von dem zweiten Schaltungsträger in das Trägerelement zu übertragen. Kleben ist eine besonders einfache Möglichkeit des Fügens von zwei Elementen. Natürlich könnte der zweite Schaltungsträger und das Trägerelement miteinander verlötet sein. Hierbei sind sowohl das Löten als auch das Kleben stoffschlüssige Verbindungen.

Gemäß einem weiteren Ausgestaltungsbeispiel der Erfindung ist eine Deckelstruktur mit dem ersten Schaltungsträger fest verbunden. Der erste Schaltungsträger, das Trägerelement und die Deckelstruktur begrenzen einen Innenraum, wobei der Innenraum von einem Außenraum fluiddicht getrennt ist. Der zweite Schaltungsträger ist in dem Innenraum angeordnet.

Eine derartige Ausgestaltung kann es erlauben, dass das Steuergerät von einem als Wärmesenke ausgebildeten Fluid umspült werden kann. Damit kann das Steuergerät beispielsweise innerhalb eines Automatikgetriebes angeordnet werden, ohne dass der Innenraum des Steuergeräts mit Automatikgetriebeöl kontaktiert wird. Die Deckelstruktur kann beispielsweise aus Kunststoff oder Metall gefertigt sein. Auch kann der für die Deckelstruktur verwendete Kunststoff faserverstärkt sein.

Gemäß einem weiteren Ausgestaltungsbeispiel der Erfindung erstreckt sich der erste Schaltungsträger zu einem in dem Außenraum angeordneten elektrischen Bauelement. Das in dem Außenraum angeordnete elektrische Bauelement ist mit dem zweiten Schaltungsträger elektrisch leitfähig verbunden.

Die in dem Außenraum angeordneten elektrischen Bauelemente werden meist Sensoren oder fest mit dem ersten Schaltungsträger verbundene Steckverbinder sein, die an Aktuatoren wie beispielweise Elektromotore elektrisch leitfähig verbunden werden können.

Gemäß einem weiteren Ausgestaltungsbeispiel der Erfindung sind die Deckelstruktur und der zweite Schaltungsträger miteinander verklebt.

Hierdurch ergibt sich eine besonders einfache und kostensparende fluiddichte Verbindung zwischen der Deckelstruktur und dem zweiten Schaltungsträger.

Gemäß einem weiteren Ausgestaltungsbeispiel der Erfindung weist die Deckelstruktur ein Dichtelement auf, wobei das Dichtelement eingerichtet ist, ein Eindringen von Fluid von dem Außenraum in den Innenraum zwischen der Deckelstruktur und dem zweiten Schaltungsträger zu verhindern.

Damit kommt der zweite Schaltungsträger nicht mit dem das Steuergerät umgebende Fluid, respektive Automatikgetriebeöl oder mit Schwebstoffen in Verbindung, die in dem Automatikgetriebeöl enthalten sein können. Insbesondere die Schwebstoffe können aufgrund von metallischem Abrieb möglicherweise elektrisch leitfähig sein.

Gemäß einem weiteren Ausgestaltungsbeispiel der Erfindung weist ein Automatikgetriebe für ein Kraftfahrzeug ein wie vorhergehend beschriebenes Steuergerät mit einem Getriebegehäuse auf, wobei das Steuergerät innerhalb des Getriebegehäuses angeordnet ist.

Gemäß einem weiteren Ausgestaltungsbeispiel der Erfindung wird ein Verfahren zur Herstellung eines Steuergeräts für ein Kraftfahrzeug bereitgestellt, wobei das Verfahren folgende Schritte aufweist. Einbetten eines Trägerelements in einen ersten Schaltungsträger während dessen Herstellprozesses in fluiddichter Weise. Freilegen eines Mittelbereichs des Trägerelements durch Herstellung einer Ausnehmung. Positionieren und Verbinden in gut wärmeleitfähiger Weise eines zweiten Schaltungsträgers mit seinen elektrischen Bauelementen. Verbinden des ersten Schaltungsträgers und des zweiten Schaltungsträgers in elektrisch leitfähiger Weise. Festes Verbinden einer Deckelstruktur mit dem ersten Schaltungsträger in fluiddichter Weise. Verbinden von elektrischen Bauelementen an den ersten Schaltungsträger in elektrisch leitfähiger Weise.

Es wird angemerkt, dass Gedanken zu der Erfindung hierin im Zusammenhang mit einem Steuergerät als auch mit einem Verfahren zur Herstellung eines Steuergeräts beschrieben sind. Einem Fachmann ist hierbei klar, dass die einzelnen beschriebenen Merkmale auf verschiedene Weise miteinander kombiniert werden können, um so auch zu anderen Ausgestaltungen der Erfindung zu gelangen.

### Kurze Beschreibung der Zeichnungen

Ausführungsformen der Erfindung werden nachfolgend mit Bezug auf die beigefügten Figuren beschrieben. Die Figuren sind lediglich schematisch und nicht maßstabsgetreu.
- Figur 1: zeigt ein Steuergerät mit einem ersten und einem zweiten Schaltungsträger, wobei der zweite Schaltungsträger an einem in dem ersten Schaltungsträger einlaminierten Trägerelement angeordnet ist, im Querschnitt;
- Figur 2: zeigt das aus Figur 1 bekannte Steuergerät in Verbindung mit einer als Hydraulikplatte ausgebildeten Wärmesenke im Querschnitt;
- Figur 3: zeigt das aus Figur 1 bekannte Steuergerät in Verbindung mit einer als Fluid ausgebildeten Wärmesenke im Querschnitt;
- Figur 4: zeigt das aus Figur 2 bekannte Steuergerät, das in einem Automatikgetriebe eines Kraftfahrzeugs eingebaut ist, im Röntgenblick; und
- Figur 5: zeigt ein Verfahren zum Herstellen des aus den Figuren 1 bis 4 bekannten Steuergeräts für ein Automatikgetriebe eines Kraftfahrzeugs.

### Detaillierte Beschreibung beispielhafter Ausführungsformen

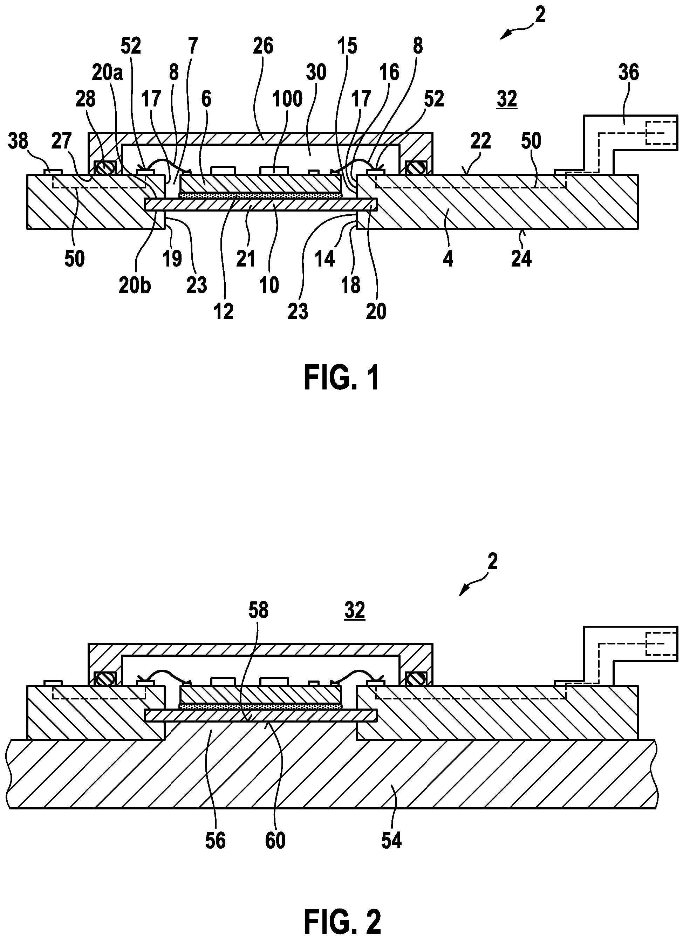

Figur 1 zeigt ein Steuergerät 2, welches als ein Steuergerät 2 für Automatikgetriebe moderner Kraftfahrzeuge ausgebildet ist. Das Steuergerät 2 besitzt einen ersten Schaltungsträger 4 und einen zweiten Schaltungsträger 6, wobei der erste Schaltungsträger 4 und der zweite Schaltungsträger 6 voneinander mittels eines Spalts 7 umlaufend voneinander getrennt sind. Der erste Schaltungsträger 4 und der zweite Schaltungsträger 6 sind miteinander mittels Bonddrähten 8 elektrisch leitfähig verbunden. Der zweite Schaltungsträger 6 und ein fluiddichtes wärmeleitfähiges Trägerelement 10 sind mittels eines gut wärmeleitfähigen Klebstoffs 12 miteinander wärmeleitfähig fest verbunden. Das Trägerelement 10 ist plattenförmig ausgebildet und besteht in dem vorliegenden Ausgestaltungsbeispiel aus einer Aluminiumlegierung. Das Trägerelement 10 kann auch aus einer Kupfer- oder Nickellegierung gefertigt sein. Der erste Schaltungsträger 4 ist als Leiterplatte ausgestaltet. Die Leiterplatte ist aus Harz in Verbindung mit einem Glasfasergewebe oder einem Glasfaservlies gefertigt, wobei die Qualität des ersten Schaltungsträgers FR4 oder mehr beträgt. Der zweite Schaltungsträger 6 ist in LTCC(Low Temperature Cofired Ceramics), Dickschichtkeramik-, Leiterplatten-oder HDI(High-Density-Interconnect)-Leiterplatten-Technologie gefertigt. Das Trägerelement 10 ist in einem Innenbereich 14 des ersten Schaltungsträgers 4 fluiddicht integriert. Das Trägerelement 10 bildet einen Randbereich 20 aus, der in dem ersten Schaltungsträger 4 fluiddicht einlaminiert ist. Das Trägerelement 10 beträgt eine Dicke von etwa 1 mm. Der erste Schaltungsträger 4 besitzt eine Ausnehmung 15, die als eine erste wannenförmige Aussparung 16 ausgestaltet ist. Hierbei besitzt die wannenförmige erste Aussparung 16 eine erste Seitenwandung 17, welche durch den ersten Schaltungsträger 4 gebildet ist. Die erste Seitenwandung 17 und das Trägerelement 10 sind miteinander fluiddicht verbunden. Der ersten Aussparung 16 gegenüberliegend ist eine wannenförmige zweite Aussparung 18 angeordnet. Auch deren zweite Seitenwandung 23 ist durch den ersten Schaltungsträger 4 gebildet. Auch hier sind die zweite Seitenwandung 23 und das Trägerelement 10 miteinander fluiddicht verbunden. Die erste Aussparung 16 und die zweite Aussparung 18 befinden sich in einer Flucht. Ferner sind die erste Aussparung 16 und die zweite Aussparung 18 in dem hier beschriebenen Ausführungsbeispiel deckungsgleich ausgebildet. Somit kann die erste Aussparung 16 und die zweite Aussparung 18 ohne das Trägerelement 10 als eine sich von einer Oberseite 22 des ersten Schaltungsträgers 4 hin zu einer der Oberseite 22 gegenüberliegenden Unterseite 24 des Schaltungsträgers 4 erstreckende Öffnung 19 betrachtet werden. Hierbei wird die Öffnung durch die erste 17 und die zweite Seitenwandung 23 begrenzt. Die Durchgängigkeit der Öffnung 19 ist unterbrochen durch das Trägerelement 10, welches brückenartig die Öffnung 19 überspannt. Das Trägerlement ist umlaufend mit dem ersten schaltungsträger 4 fluiddicht verbunden. Hierzu besitzt das Trägerelements 10 einen Randbereich 20 mit einer ersten Seite 20a und einer der ersten Seite gegenüberliegenden zweiten Seite 20b. Die erste Seite 20a und die zweite Seite 20b werden von dem ersten Schaltungsträger 4 überdeckt. Ein von dem Randbereich 20 begrenzter Mittelbereich 21 des Trägerelements 10 ist von der Oberseite 22 als auch von der Unterseite 24 des ersten Schaltungsträgers 4 frei zugänglich. Der zweite Schaltungsträger 6 ist hierbei an dem Mittelbereich 21 des Trägerelements 10 angeordnet. Eine wannenförmig ausgebildete Deckelstruktur 26 ist mit der Oberseite 22 des ersten Schaltungsträgers 4 fest verbunden. Die Deckelstruktur 26 besitzt einen der Oberseite 22 des ersten Schaltungsträgers 4 zugewandten U-förmig ausgebildeten Rand 27, in welchem ein umlaufendes Dichtungselement 28 angeordnet ist, das als O-Ring ausgebildet ist. Somit wird durch den ersten Schaltungsträger 4, das Trägerelement 10 und die Deckelstruktur 26 ein Innenraum 30 begrenzt, der von einem Außenraum 32 fluiddicht getrennt ist. Der zweite Schaltungsträger 6 mit seinen elektrischen Bauelementen 100 ist in dem Innenraum 30 angeordnet. In dem Außenraum 32 befinden sich an dem zweiten Schaltungsträger 6 angeordnete elektrische Bauelemente in Form eines Steckers 36 sowie eines Sensors 38. Innerhalb des ersten Schaltungsträgers 4 sind Leiterbahnen 50 angeordnet, welche die außerhalb des Innenraums 30 angeordneten elektrischen Bauelemente 36, 38 mit innerhalb des Innenraums 30 angeordneten Kontaktpunkten 52 verbinden.

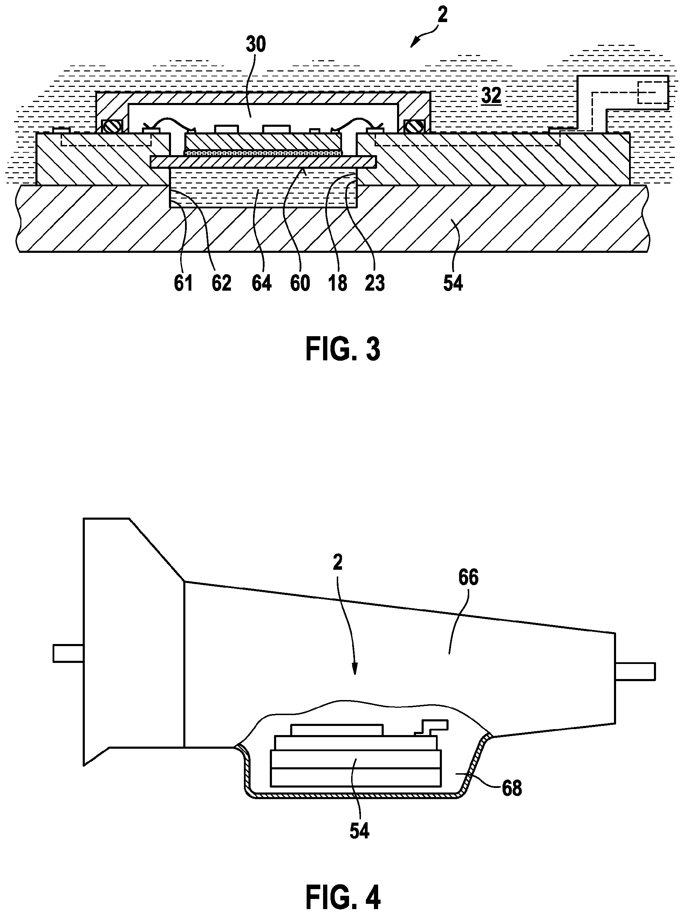

Dadurch, dass der zweite Schaltungsträger 6 innerhalb der Ausnehmung 15 angeordnet ist, baut das Steuergerät 2 sehr flach. Die von dem ersten Schaltungsträger 4 erzeugte Wärme wird nahezu wärmewiderstandsfrei in das Trägerelement 10 geleitet. Da das Trägerelement 10 lediglich ein geringes Volumen aufweist, ist in erwünschter Weise nahezu keine Wärmespeicherung vorhanden. Um die in dem Trägerelement 10 vorhandene Wärme abzuführen, kann an das Trägerelement 10 eine Wärmesenke angeordnet werden, wie dies in den folgenden Figuren 2 und 3 dargestellt ist.

Figur 2 zeigt das aus Figur 1 bekannte Steuergerät 2 in Verbindung mit einer als Hydraulikplatte 54 ausgebildeten Wärmesenke im Querschnitt. Die Hydraulikplatte 54 besitzt einen Vorsprung 56, welcher eine zu einer Unterfläche 60 des Trägerelements 10 korrespondierende Aufnahmefläche 58 besitzt. Hierbei sind die Aufnahmefläche 58 der Hydraulikplatte 54 und die Unterfläche 60 des Trägerelements aneinander wärmeleitend verbunden. Somit kann die in dem Trägerelement 10 vorhandene Wärme in die Hydraulikplatte 54 eingeleitet werden.

Figur 3 zeigt das aus Figur 1 bekannte Steuergerät 2 in Verbindung mit einer aus Automatikgetriebeöl 64 gebildeten Wärmesenke. Hierbei ist in der Hydraulikplatte 54 eine Nut 61 ausgebildet. Die Nut 61 bildet mit der zweiten Seitenwandung 23 der zweiten Aussparung 18 und der Unterfläche 60 des Trägerelements 10 eine Kanal 62 aus, in dem das Automaikgetriebeöl 64 geführt ist. Zudem befindet sich das Automatikgetriebeöl 64 auch in dem Außenraum 32. Insbesondere ist das Trägerelement 10 derart mit dem ersten Schaltungsträger 4 fluiddicht verbunden, dass kein Automatikgetriebeöl 64 aus dem Kanal 62 in den Innenraum 30 des Steuergeräts 2 gelangen kann. In dem Kanal 62 wird das Automatikgetriebeöl 64 dem Trägerelement 10 zugeführt, um mittels des Automatikgetriebeöls 64 die in dem Trägerelement 10 vorhandene Wärme abzuführen. Insbesondere ist der Kanal 62 derart gestaltet, dass das in dem Kanal 62 geführte Automatikgetriebeöl 64 zirkuliert, um die Wärme aus der Trägerplatte 10 möglichst effektiv abzuführen.

Figur 4 zeigt ein Automatikgetriebe 66 mit einer Ölwanne 68. Hierbei ist die aus Figur 2 und/oder Figur 3 bekannte Hydraulikplatte 54 mit dem Steuergerät 2 in der Ölwanne 68 des Automatikgetriebes 66 angeordnet, wobei die Ölwanne 68 während des Betriebs des Kraftfahrzeugs durch Fahrtwind gekühlt wird, so dass die in die Hydraulikplatte 54 geleitete Wärme über die Ölwanne 68 durch den Fahrtwind entzogen werden kann.

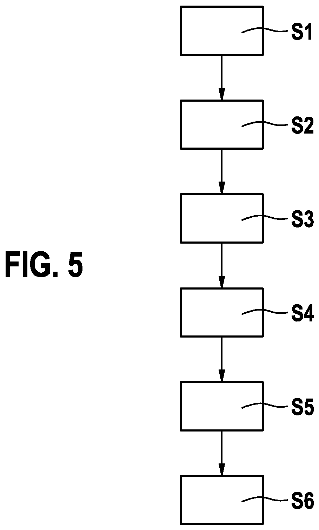

Figur 5 zeigt ein Verfahren zur Herstellung des Steuergeräts 2 für das Automatikgetriebe 66 eines Kraftfahrzeugs. Hierbei weist das Verfahren folgende Schritte auf: In einem ersten Verfahrensschritt S1 wird das Trägerelement 10 in den ersten Schaltungsträger 4 während eines Leiterplattenherstellprozesses derart eingebettet, dass es im späteren Betrieb fluiddicht ist. In einem weiteren Verfahrensschritt S2 wird der Mittelbereich 21 des Trägerelements 10 durch Ausfräsen der Ausnehmung 15 in Form der ersten Aussparung 16 und Ausfräsen der zweiten Aussparung 18 freigelegt. Dieser Verfahrensschritt S2 kann entfallen, wenn Leiterplattenschichten vor dem Verpressen und Aushärten die beiden Aussparungen 16, 18 besitzen. In diesem Verfahrensschritt wird der Mittelbereich 21 metallisch blank bereitgestellt. In einem weiteren Verfahrensschritt S3 wird der zweite Schaltungsträger 6 mit seinen elektrischen Bauelementen 100 auf dem Mittelbereich 21 positioniert und mit dem Mittelbereich 21 gut wärmeleitfähig verbunden. Dies kann beispielsweise durch ein Andrücken des zweiten Schaltungsträgers 6 an den Mittelbereich 21 oder durch ein Verkleben des Mittelbereichs 21 und des des zweiten Schaltungsträgers 6 erfolgen. In einem weiteren Verfahrensschrift S4 werden der erste Schaltungsträger 4 und der zweite Schaltungsträger 6 beispielsweise durch Bondddrähte 8 oder andere elektrische Verbindungselemente miteinander elektrisch leitfähig verbunden. In einem weiteren Verfahrensschritt S5 wird eine Deckelstruktur 26 mit einer Oberseite 22 des ersten Schaltungsträgers 4 fluiddicht fest verbunden. In einem weiteren Verfahrensschritt S6 werden weitere elektrische Bauelemente 36, 48 an den ersten Schaltungsträger 4 unlösbar befestigt und elektrisch leitfähig verbunden.

## Patentansprüche

1. Steuergerät für ein Kraftfahrzeug, das Steuergerät aufweisend
einen ersten Schaltungsträger (4)
einen zweiten Schaltungsträger (6) mit miteinander elektrisch leitfähig verbundenen elektrischen Bauelementen (100),
wobei der erste Schaltungsträger (4) und der zweite Schaltungsträger (6) miteinander elektrisch leitfähig verbunden sind,
wobei der zweite Schaltungsträger (6) mit einem fluiddichten wärmeleitfähigen Trägerelement (10) wärmeleitfähig fest verbunden ist,
wobei der erste Schaltungsträger (4) eine Ausnehmung (15) aufweist,
wobei der zweite Schaltungsträger (6) in der Ausnehmung (15) angeordnet ist, wobei das Trägerelement (10) in der Ausnehmung (15) angeordnet ist,
wobei das Trägerelement (10) eine bessere Wärmeleitfähigkeit aufweist als der erste Schaltungsträger (4),
wobei das Trägerelement (10) an eine Wärmesenke (56, 64) wärmeleitfähig verbindbar ist,
wobei das Trägerelement (10) in einem Innenbereich (14) des ersten Schaltungsträgers (4) fluiddicht integriert ist,
**dadurch gekennzeichnet,**
**dass** der erste Schaltungsträger (4) mit miteinander elektrisch leitfähig verbundenen elektrischen Bauelementen (36, 38) versehen ist,
**dass** der erste Schaltungsträger (4) einen sich von einer Oberseite (22) zu einer der Oberseite gegenüberliegenden Unterseite (24) erstreckenden Durchbruch aufweist, der von dem Trägerelement (10) fluiddicht verschlossen wird, dass der erste Schaltungsträger (4) als Leiterplatte aus Harz in Verbindung mit einem Glasfaserflies oder -gewebe ausgestaltet ist und
**dass** das Trägerelement (10) einen Randbereich (20) ausbildet, der in dem ersten Schaltungsträger (4) fluiddicht einlaminiert ist.

2. Steuergerät nach Anspruch 1,
**dadurch gekennzeichnet, dass**
das Trägerelement (10) einen Randbereich (20) mit einer ersten Seite (20a) und einer der ersten Seite (20a) gegenüberliegenden zweiten Seite (20b) aufweist,
wobei sowohl die erste (20a) als auch die zweite Seite (20b) zumindest teilweise von dem ersten Schaltungsträger (4) überdeckt sind.

3. Steuergerät nach Anspruch 1 oder 2,
**dadurch gekennzeichnet, dass**
das Trägerelement (10) gefertigt ist aus einem Werkstoff ausgewählt aus der Gruppe Kupfer, Kupferlegierung, Aluminium, Aluminiumlegierung und Nickellegierung.

4. Steuergerät nach einem der vorhergehenden Ansprüche,
**dadurch gekennzeichnet, dass**
die Ausnehmung (15) des ersten Schaltungsträgers (4) als eine erste Aussparung (16) ausgebildet ist
und der erste Schaltungsträger (4) eine von der ersten Aussparung (16) verschiedene zweite Aussparung (18) aufweist,
wobei die erste Aussparung (16) und die zweite Aussparung (18) eine sich von der Oberseite (22) des ersten Schaltungsträgers (4) hin zu einer der Oberseite gegenüberliegenden Unterseite erstreckende Öffnung (19) bilden, die durch eine erste Seitenwandung (17) der ersten Aussparung (16) und eine zweite Seitenwandung (23) der zweiten Aussparung (18) begrenzt wird, wobei die Durchgängigkeit der Öffnung (19) durch das Trägerelement (10) unterbrochen ist, welches die Öffnung (19) brückenartig überspannt.

5. Steuergerät nach Anspruch 4,
**dadurch gekennzeichnet, dass**
die erste Aussparung (16) und die zweite Aussparung (18) in einer Flucht angeordnet sind.

6. Steuergerät nach einem der vorhergehenden Ansprüche,
**dadurch gekennzeichnet, dass**
eine Deckelstruktur (26) mit dem ersten Schaltungsträger (4) fest verbunden ist,
wobei der erste Schaltungsträger (4), das Trägerelement (10) und die Deckelstruktur (26) einen Innenraum (30) begrenzen,
wobei der Innenraum (30) von einem Außenraum (32) fluiddicht getrennt ist, wobei der zweite Schaltungsträger (6) in dem innenraum (30) angeordnet ist.

7. Steuergerät nach Anspruch 6,
**dadurch gekennzeichnet, dass**
die Deckelstruktur (26) und der erste Schaltungsträger (4) miteinander verklebt sind.

8. Steuergerät nach Anspruch 6,
**dadurch gekennzeichnet, dass**
die Deckelstruktur (26) ein Dichtelement (28) aufweist, wobei das Dichtelement (28) eingerichtet ist, ein Eindringen von Fluid von dem Außenraum (32) in den Innenraum (30) zwischen der Deckelstruktur (26) und dem ersten Schaltungsträger (4) zu verhindern.

9. Automatikgetriebe für ein Kraftfahrzeug mit einem Steuergerät nach einem der Ansprüche 1 bis 8,
wobei das Automatikgetriebe ein Gehäuse aufweist,
wobei das Steuergerät innerhalb des Gehäuses angeordnet ist.

10. Verfahren zum Herstellen eines Steuergeräts (2) für ein Kraftfahrzeug, wobei das Verfahren folgende Schritte aufweist:
Einbetten (S1) eines Trägerelements (10) in einen ersten Schaltungsträger (4) während dessen Herstellprozesses in fluiddichter Weise,
wobei der erste Schaltungsträger (4) als Leiterplatte aus Harz in Verbindung mit einem Glasfaserflies oder -gewebe ausgestaltet ist,
Freilegen (S2) eines Mittelbereichs (21) des Trägerelements (10) durch Herstellung einer Ausnehmung (15) durch Ausfräsen einer ersten Aussparung (16) und einer zweiten Aussparung (18), wobei die erste und die zweite Aussparung (16,18) einander gegenüberliegend angeordnet sind und durch das Trägerelement (10) getrennt sind,
Positionieren und Verbinden (S3) in gut wärmeleitfähiger Weise eines zweiten Schaltungsträgers (6) mit seinen elektrischen Bauelementen (100) auf dem frei gelegten Mittelbereich (21) des Trägerelements (10),
Verbinden (S4) des ersten Schaltungsträgers (4) und des zweiten Schaltungsträgers (6) in elektrisch leitfähiger Weise,festes Verbinden (S5) einer Deckelstruktur (26) mit dem ersten Schaltungsträger (4) in fluiddichter Weise derart, dass durch den ersten Schaltungsträger (4), das Trägerelement (10) und die Deckelstruktur (26) ein Innenraum (30) begrenzt wird, in dem der zweite Schaltungsträger (6) angeordnet ist und weicher Innenraum (30) von einem Außenraum (32) fluiddicht getrennt ist,
Verbinden (S6) von elektrischen Bauelementen (36, 48) an den ersten Schaltungsträger (4) in elektrisch leitfähiger Weise.

## Claims

1. Control device for a motor vehicle, the control device having
a first circuit mount (4)
a second circuit mount (6) with electrical components (100) which are electrically conductively connected to one another,
wherein the first circuit mount (4) and the second circuit mount (6) are electrically conductively connected to one another,
wherein the second circuit mount (6) is thermally conductively and fixedly connected to a fluid-tight thermally conductive mount element (10),
wherein the first circuit mount (4) has a recess (15),
wherein the second circuit mount (6) is arranged in the recess (15),
wherein the mount element (10) is arranged in the recess (15),
wherein the mount element (10) has a better thermal conductivity than the first circuit mount (4),
wherein the mount element (10) can be thermally conductively connected to a heat sink (56, 64),
wherein the mount element (10) is integrated into an inner region (14) of the first circuit mount (4) in a fluid-tight manner,
**characterized**
**in that** the first circuit mount (4) is provided with electrical components (36, 38) which are electrically conductively connected to one another,
**in that** the first circuit mount (4) has an aperture which extends from a top face (22) to a bottom face (24), which is situated opposite the top face, and is closed in a fluid-tight manner by the mount element (10),
**in that** the first circuit mount (4) is designed as a printed circuit board composed of resin in conjunction with a glass-fibre nonwoven fabric or a glass-fibre woven fabric, and
**in that** the mount element (10) forms an edge region (20) which is incorporated by lamination into the first circuit mount (4) in a fluid-tight manner.

2. Control device according to Claim 1,
**characterized in that**
the mount element (10) has an edge region (20) with a first side (20a) and a second side (20b) which is situated opposite the first side (20a),
wherein both the first side (20a) and also the second side (20b) are at least partially covered by the first circuit mount (4).

3. Control device according to Claim 1 or 2,
**characterized in that**
the mount element (10) is produced from a material which is selected from the group comprising copper, copper alloy, aluminum, aluminum alloy and nickel alloy.

4. Control device according to one of the preceding claims,
**characterized in that**
the recess (15) in the first circuit mound (4) is in the form of first cutout (16),
and the first circuit mount (4) has a second cutout (18) which is different from the first cutout (16),
wherein the first cutout (16) and the second cutout (18) form an opening (19) which extends from a top face (22) of the first circuit mount (4) to a bottom face which is situated opposite the top face, which opening is bounded by a first side wall (17) of the first cutout (16) and a second side wall (23) of the second cutout (18), wherein the ability to pass through the opening (19) is interrupted by the mount element (10) which spans the opening (19) in a bridge-like manner.

5. Control device according to Claim 4,
**characterized in that**
the first cutout (16) and the second cutout (18) are arranged in alignment.

6. Control device according to one of the preceding claims,
**characterized in that**
a cover structure (26) is fixedly connected to the first circuit mount (4),
wherein the first circuit mount (4), the mount element (10) and the cover structure (26) bound an internal space (30),
wherein the internal space (30) is separated from an external space (32) in a fluid-tight manner, wherein the second circuit mount (6) is arranged in the internal space (30).

7. Control device according to Claim 6,
**characterized in that**
the cover structure (26) and the first circuit mount (4) are adhesively bonded to one another.

8. Control device according to Claim 6,
**characterized in that**
the cover structure (26) has a sealing element (28), wherein the sealing element (28) is designed to prevent any ingress of fluid from the external space (32) into the internal space (30) between the cover structure (26) and the first circuit mount (4).

9. Automatic transmission for a motor vehicle, having a control device according to one of Claims 1 to 8,
wherein the automatic transmission has a housing,
wherein the control device is arranged within the housing.

10. Method for producing a control device (2) for a motor vehicle, wherein the method comprises the following steps:
embedding (S1) a mount element (10) into a first circuit mount (4) during the production process of said circuit mount in a fluid-tight manner,
wherein the first circuit mount (4) is designed as a printed circuit board composed of resin in conjunction with a glass-fibre nonwoven fabric or a glass-fibre woven fabric,
exposing (S2) a central region (21) of the mount element (10) by producing a recess (15) by milling a first cutout (16) and a second cutout (18), wherein the first and the second cutout (16, 18) are arranged in a manner situated opposite one another and are separated by the mount element (10),
positioning and connecting (S3) a second circuit mount (6) together with its electrical components (100) in a highly thermally conductive manner on the exposed central region (21) of the mount element (10),
connecting (S4) the first circuit mount (4) and the second circuit mount (6) in an electrically conductive manner, fixedly connecting (S5) a cover structure (26) to the first circuit mount (4) in a fluid-tight manner in such a way that an internal space (30) is bounded by the first circuit mount (4), the mount element (10) and the cover structure (26), the second circuit mount (6) being arranged in said internal space and said internal space (30) being separated from an external space (32) in a fluid-tight manner,
connecting (S6) electrical components (36, 48) to the first circuit mount (4) in an electrically conductive manner.

## Revendications

1. Appareil de commande pour un véhicule automobile, l'appareil de commande présentant
un premier support de circuit (4),
un deuxième support de circuit (6) avec des composants électriques (100) connectés de manière électriquement conductrice les uns aux autres,
le premier support de circuit (4) et le deuxième support de circuit (6) étant connectés l'un à l'autre de manière électriquement conductrice,
le deuxième support de circuit (6) étant connecté fixement de manière thermoconductrice à un élément de support (10) thermoconducteur étanche aux fluides,
le premier support de circuit (4) présentant un évidement (15),
le deuxième support de circuit (6) étant disposé dans l'évidement (15),
l'élément de support (10) étant disposé dans l'évidement (15),
l'élément de support (10) présentant une meilleure conductibilité thermique que le premier support de circuit (4),
l'élément de support (10) pouvant être connecté de manière thermoconductrice à un puits thermique (56, 64),
l'élément de support (10) étant intégré de manière étanche aux fluides dans une région interne (14) du premier support de circuit (4),
**caractérisé**
**en ce que** le premier support de circuit (4) est pourvu de composants électriques (36, 38) connectés de manière électriquement conductrice les uns aux autres,
**en ce que** le premier support de circuit (4) présente un orifice s'étendant depuis un côté supérieur (22) jusqu'à un côté inférieur (24) opposé au côté supérieur, lequel orifice est fermé de manière étanche aux fluides par l'élément de support (10),
**en ce que** le premier support de circuit (4) est configuré sous forme de carte à circuits intégrés en résine en association avec un non-tissé ou un tissu en fibre de verre et
**en ce que** l'élément de support (10) constitue une région de bord (20) qui est incorporée par laminage de manière étanche aux fluides dans le premier support de circuit (4).

2. Appareil de commande selon la revendication 1,
**caractérisé en ce que**
l'élément de support (10) présente une région de bord (20) avec un premier côté (20a) et un deuxième côté (20b) opposé au premier côté (20a), le premier (20a) et le deuxième (20b) côté étant recouverts au moins en partie par le premier support de circuit (4).

3. Appareil de commande selon la revendication 1 ou 2,
**caractérisé en ce que**
l'élément de support (10) est fabriqué en un matériau choisi parmi le groupe constitué du cuivre, d'un alliage de cuivre, d'aluminium, d'un alliage d'aluminium et d'un alliage de nickel.

4. Appareil de commande selon l'une quelconque des revendications précédentes,
**caractérisé en ce que**
l'évidement (15) du premier support de circuit (4) est réalisé sous forme de premier évidement (16), et le premier support de circuit (4) présente un deuxième évidement (18) différent du premier évidement (16),
le premier évidement (16) et le deuxième évidement (18) formant une ouverture (19) s'étendant depuis le côté supérieur (22) du premier support de circuit (4) jusqu'à un côté inférieur opposé au côté supérieur, laquelle ouverture est délimitée par une première paroi latérale (17) du premier évidement (16) et par une deuxième paroi latérale (23) deuxième évidement (18), le passage à travers l'ouverture (19) étant interrompu par l'élément de support (10) qui surmonte l'ouverture (19) à la manière d'un pont.

5. Appareil de commande selon la revendication 4,
**caractérisé en ce que**
le premier évidement (16) et le deuxième évidement (18) sont disposés en alignement.

6. Appareil de commande selon l'une quelconque des revendications précédentes,
**caractérisé en ce que**
une structure de couvercle (26) est connectée fixement au premier support de circuit (4),
le premier support de circuit (4), l'élément de support (10) et la structure de couvercle (26) délimitant un espace interne (30),
l'espace interne (30) étant séparé de manière étanche aux fluides par un espace externe (32),
le deuxième support de circuit (6) étant disposé dans l'espace interne (30).

7. Appareil de commande selon la revendication 6,
**caractérisé en ce que**
la structure de couvercle (26) et le premier support de circuit (4) sont collés l'un à l'autre.

8. Appareil de commande selon la revendication 6,
**caractérisé en ce que**
la structure de couvercle (26) présente un élément d'étanchéité (28), l'élément d'étanchéité (28) étant prévu pour empêcher une pénétration de fluide depuis l'espace externe (32) dans l'espace interne (30) entre la structure de couvercle (26) et le premier support de circuit (4).

9. Boîte de vitesses automatique pour un véhicule automobile comprenant un appareil de commande selon l'une quelconque des revendications 1 à 8, dans laquelle la boîte de vitesses automatique présente un boîtier,
dans laquelle l'appareil de commande est disposé à l'intérieur du boîtier.

10. Procédé de fabrication d'un appareil de commande (2) pour un véhicule automobile, le procédé présentant les étapes suivantes :
incorporation (S1) d'un élément de support (10) dans un premier support de circuit (4) de manière étanche aux fluides pendant son processus de fabrication,
le premier support de circuit (4) étant réalisé sous forme de carte à circuits imprimés en résine en association avec un non-tissé ou un tissu en fibre de verre,
exposition (S2) d'une région centrale (21) de l'élément de support (10) en réalisant un évidement (15) par fraisage d'un premier renfoncement (16) et d'un deuxième renfoncement (18), le premier et le deuxième renfoncement (16, 18) étant disposés en face l'un de l'autre et étant séparés par l'élément de support (10),
positionnement et connexion (S3) de manière bien thermoconductrice d'un deuxième support de circuit (6) avec ses composants électriques (100) sur la région centrale exposée (21) de l'élément de support (10),
connexion (S4) du premier support de circuit (4) et du deuxième support de circuit (6) de manière électriquement conductrice,
connexion fixe (S5) d'une structure de couvercle (26) au premier support de circuit (4) de manière étanche aux fluides de telle sorte qu'un espace interne (30) soit limité par le premier support de circuit (4), l'élément de support (10) et la structure de couvercle (26), dans lequel espace interne est disposé le deuxième support de circuit (6) et lequel espace interne (30) étant séparé de manière étanche aux fluides d'un espace externe (32),
connexion (S6) de composants électriques (36, 48) au premier support de circuit (4) de manière électriquement conductrice.
